# EUROPÄISCHE PATENTSCHRIFT

(11) **EP 1 729 416 B1**
(45) Veröffentlichungstag und Bekanntmachung des Hinweises auf die Patenterteilung: **03.06.2009**
(21) Anmeldenummer: 06010910.5
(22) Anmeldetag: 27.05.2006
(51) Int. Cl.: H03K 17/18, H03K 17/691

(54) **Schaltungsanordnung mit Fehlerübermittlung und zugehöriges Verfahren zur Ansteuerung von Leistungshalbleiterschaltern**
Circuit with error signalling and method thereof for controlling semiconductor power switches
Circuit avec signalement d'erreurs et procédé associé pour la commande de commutateurs de puissance semi-conducteurs

(30) Priorität: 04.06.2005 DE 102005025705
(43) Veröffentlichungstag der Anmeldung: 06.12.2006
(73) Patentinhaber: SEMIKRON Elektronik GmbH & Co. KG, 90431 Nürnberg (DE)
(72) Erfinder: Lehmann, Jan, 98693 Ilmenau (DE)

(56) Entgegenhaltungen:
- EP-A- 0 268 930
- EP-A- 0 708 529
- DE-A1- 4 007 539

## Beschreibung

Die Erfindung betrifft eine Schaltungsanordnung zur Ansteuerung von Leistungsschaltern angeordnet in Brückenschaltungstopologie sowie ein zugehöriges Verfahren. Derartige Brückenanordnungen von Leistungsschaltern sind als Halb-, H-(Zweiphasen-), oder als Dreiphasenbrückenschaltungen bekannt, wobei die einphasige Halbbrücke den Grundbaustein derartiger leistungselektronischer Schaltungen darstellt. In einer Halbbrückenschaltung sind zwei Leistungsschalter, ein erster, sog. TOP- Schalter und ein zweiter sog. BOT-Schalter in einer Reihenschaltung angeordnet. Eine derartige Halbbrücke weist in der Regel eine Verbindung zu einem Gleichstromzwischenkreis auf. Die Mittelanzapfung ist typischerweise mit einer Last verbunden.

Bei Ausgestaltung der Leistungsschalter als ein Leistungshalbleiterbauelement, oder als eine Mehrzahl gleichartiger in Reihe oder parallel geschalteter Leistungshalbleiterbauelemente, ist zur Ansteuerung der Leistungsschalter eine Ansteuerschaltung notwendig. Derartige Ansteuerschaltungen bestehen nach dem Stand der Technik aus mehreren Teilschaltungen bzw. Funktionsblöcken. Das von einer übergeordneten Steuerung kommende Ansteuersignal wird in einer ersten Teilschaltung, der Primärseite, aufbereitet und über weitere Komponenten den Treiberschaltungen, den Sekundärseiten, und schließlich dem Steuereingang des jeweiligen Leistungsschalters zugeführt. Bei Halbbrückenanordnungen mit höheren Zwischenkreisspannungen, beispielhaft größer 50V, wird die Primärseite zur Aufbereitung der Steuersignale potentialmäßig / galvanisch von der Sekundärseite getrennt, da sich die Leistungsschalter, zumindest der TOP- Schalter der Halbbrücke im Betrieb auf keinem konstanten Potential befinden und somit eine spannungsmäßige Isolation unumgänglich ist. Diese Trennung erfolgt nach dem Stand der Technik beispielhaft mittels Übertragern, Optokopplern oder auch Lichtwellenleitern. Diese galvanische Trennung wird zumindest für den TOP-Schalter ausgeführt, ist aber auch bei höheren Leistungen für den BOT- Schalter auf Grund eines möglichen Verrisses des Masse- Bezugspotentials beim Schalten notwendig, bzw. generell notwendig im Falle des Einsatzes symmetrisch geerdeter Zwischenkreise.

Bekannt sind auch integrierte Schaltungsanordnungen für Leistungsschalter der Spannungsklassen bis 600V oder 1200V, die auf eine externe galvanische Trennung verzichten. Bei diesen monolithisch integrierten Schaltungen werden nach dem Stand der Technik so genannte Levelshifter, zumindest für den TOP- Schalter, eingesetzt.

Als besonders vorteilhaft für einen hybriden Aufbau haben sich Übertrager erwiesen, da hiermit grundsätzlich nicht nur eine Signalübertragung von der Primärseite zur Sekundärseite möglich ist, sondern auch eine Übertragung in entgegen gesetzter Richtung.

Diese Rückübertragung ist nach dem Stand der Technik (Nicolai, et al., Applikationshandbuch IGBT- und MOSFET- Leistungsmodule, ISBN 3-932 633-24-5, 1998, Seite 187-190) allerdings stark eingeschränkt, da während der überwiegenden Zeit der Übertragungskanal für Ansteuerimpulse des Leistungshalbleiterschalters-frei sein muss. Daher ist nur ein sehr begrenzter Zeitraum nach einem Steuerimpuls von der Primärseite an die Sekundärseite frei für die Übertragung eines Fehlerimpulses von der Sekundärseite zur Primärseite. Aus diesem Grund ist in bekannten Schaltungsanordnungen nur die Übertragung genau eines Fehlerimpulses vorgesehen.

Eine Übertragung weitergehender Informationen zum aufgetretenen Fehler oder zu anderen Statusinformationen über den Übertrager ist nicht bekannt. Die Übertragung derartiger Informationen ist nur über zusätzliche Übertragungskanäle, beispielhaft in Form von Optokopplern oder zusätzlichen Übertragern, bekannt, allerdings kommerziell selten realisiert, da der Kostenaufwand hierfür zu hoch ist.

Der Erfindung liegt die Aufgabe zugrunde, eine verbesserte Schaltungsanordnung für Leistungshalbleiterschalter in Brückenanordnung sowie ein zugehöriges Verfahren vorzustellen, wobei gleichzeitig der zusätzliche Aufwand in Form von Bauelementen und Herstellungskosten der Schaltungsanordnung gering bleibt.

Die Aufgabe wird erfindungsgemäß gelöst, durch die Maßnahmen der Merkmale der Ansprüche 1 und 2. Bevorzugte Ausführungsformen sind in den Unteransprüchen beschrieben.

Der erfinderische Gedanke geht aus von einer bekannten Schaltungsanordnung zur Ansteuerung von Leistungshalbleiterschaltern in Brückentopologie bestehend aus einem primärseitigen Teil (Primärseite) und pro Leistungshalbleiterschalter einem sekundärseitigen Teil (Sekundärseite). Die Brückenschaltung besteht aus einem ersten, dem TOP und einem zweiten den BOT- Schalter. Diese sind nach dem Stand der Technik mit einem Gleichstromzwischenkreis verbunden. Der Mittenabgriff zwischen dem TOP und dem BOT-Schalter bildet den Wechselstromausgang der Brückenschaltung. Die Schaltungsanordnung zur Ansteuerung weist auf ihrer Primärseite mindestens eine Signalverarbeitung auf, deren Steuerinformationen mittels mindestens eines Übertragers (transformatorisches Wirkprinzip) potentialfrei der Ansteuerung der zugeordneten Sekundärseite dienen. Diese Sekundärseite weist ihrerseits mindestens eine Signalverarbeitung sowie mindestens eine Treiberstufe für den jeweiligen Schalter auf. Zur Energieversorgung der Sekundärseite von der Primärseite aus weist die Schaltungsanordnung mindesten einen DC/DC- Wandler (transformatorisches Wirkprinzip) auf.

Die Erfindung geht von einer Schaltungsanordnung zur Ansteuerung von Leistungshalbleiterschaltern aus, wobei zur Übermittlung von Fehler- und/oder Statusinformationen von der Sekundärseite zur Primärseite ein bereits vorhandener Übertrager verwendet wird, der nach dem Stand der Technik zur Übertragung von Ansteuersignalen von der Primärseite zur Sekundärseite sowie eines einzelnen Fehlerimpulses von der Sekundärseite zur Primärseite dient. Weiterhin weist die Schaltungsanordnung mindestens einen DC/DC- Wandler zur Spannungsversorgung der Sekundärseite von der Primärseite aus auf. EP 0 268 930 A1 zeigt eine ähnliche Schaltungsanordnung.

Erfindungsgemäß ist die Schaltungsanordnung gekennzeichnet durch auf der Sekundärseite vorgesehene Schaltungsteile, die die sekundärseitige Spannung des DC/DC-Wandlers auswerten können, sowie weitere Schaltungsteile zur Fehlerspeicherung und Übertragung der Fehler- und/oder Statusinformationen von der Sekundärseite zur Primärseite. Ebenso sind auf der Primärseite Schaltungsteile zur Einstellung verschiedener Spannungswerte an dem DC/DC- Wandler, sowie weitere Schaltungsteile zur Erfassung der über den Übertrager von der Sekundärseite zur Primärseite übertragenen Fehler- und/oder Statusinformationen vorgesehen.

Das zugehörige Verfahren dient der Übermittlung von Fehler- und/oder Statusinformationen von der Sekundärseite zur Primärseite in der erfindungsgemäßen Schaltungsanordnung. Im fehlerfreien Betreib, wie auch aus dem Stand der Technik bekannt ist, wird von der Primärseite über den DC/DC- Wandler zur Sekundärseite Energie übertragen. Hierbei wird auf der Sekundärseite eine Spannung in einem definierten, ersten Spannungsintervall eingestellt. Die Steuerimpulse für die Leistungshalbleiterschalter werden mittels Übertrager von der Primärseite auf die Sekundärseite übermittelt.

Im Fehlerfall übermittelt die Sekundärseite mittels des Übertragers einen Fehlerimpuls an die Primärseite. Daraufhin ändert die Primärseite die Energieübertragung mittels des DC/DC- Wandlers derart, dass sich die sekundärseitige Spannung in einem zweiten Spannungsintervall befindet. Hierbei weist dieses zweite Spannungsintervall zum ersten Spannungsinterfall einen Spannungsunterschied auf. Ein zugeordneter Schaltungsteil der Sekundärseite erkennt diesen Spannungsunterschied und interpretiert diesen als Umschaltbefehl in einen Diagnosemodus.

Vorteilhaft an der beschriebenen Ausgestaltung der Schaltungsanordnung und des zugehörigen Verfahrens ist, dass durch die Einführung des Diagnosemodus die Funktionalität der Schaltungsanordnung erweitert wird ohne die bekannte Funktionalität zu beeinträchtigen. Der Diagnosemodus der Sekundärseite erweitert im Fehlerfall eine Übertragung von der Sekundärseite zu Primärseite von einem einfachen Fehlerimpuls hin zu vielfältiger Informationen über den Fehler oder auch über den weiteren Status der Sekundärseite. Hierbei ist sicher ausgeschlossen, dass beispielhaft durch Einkopplung von Störsignalen in die Verbindung zwischen Primärseite und Sekundärseite, ungewollt von der Sekundärseite Steuersignale erzeugt werden und diese zu unbeabsichtigtem Einschalten des zugeordneten Leistungshalbleiterschalter und somit unter Umständen zu dessen Zerstörung führen können.

Der erfinderische Gedanke wird anhand der Ausführungsbeispiele der Fig. 1 bis 3 näher erläutert.

Fig. 1 zeigt eine Schaltungsanordnung nach dem Stand d er Technik.

Fig. 2 zeigt eine erfindungsgemäß weitergebildete Schaltungsanordnung.

Fig. 3 zeigt schematisch die Spannungsverhältnisse des DC/DC-Wandlers auf der Sekundärseite.

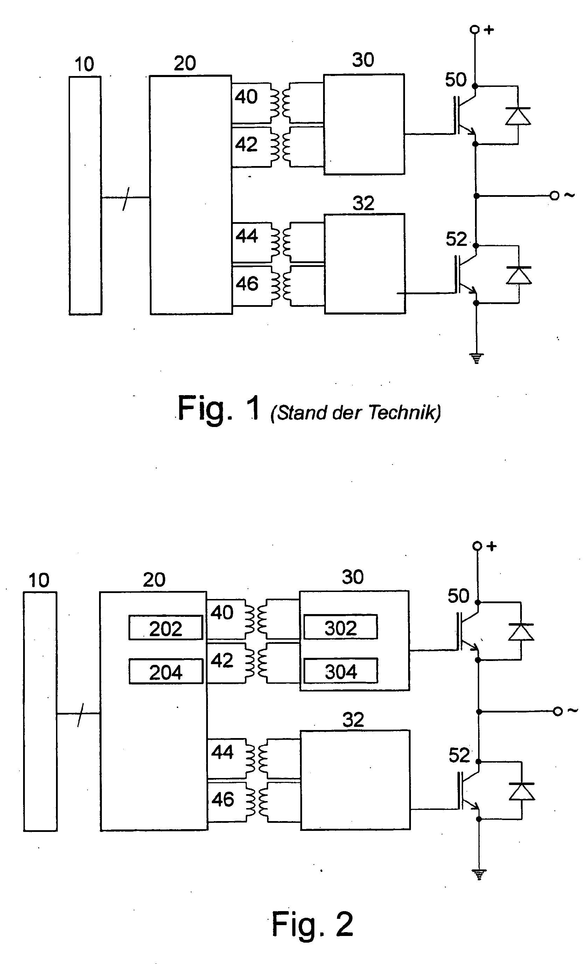

Bei der Ansteuerung von Leistungshalbleiterschaltern (50, 52), wie beispielhaft IGBTs (insulated gate bipolar transistor) mit antiparallel geschalteter Freilaufdiode, in einer Schaltungsanordnung in Brückentopologie, ist aufgrund der Spannungsdifferenz zwischen der übergeordneten Steuerung (10) beispielhaft in Form eines Mikrokontrollers (10) und der Primärseite (20) der Schaltungsanordnung gemäß Fig. 1 einerseits und der Sekundärseite (30, 32) der Schaltungsanordnung und dem Leistungshalbleiterschalter (50, 52) andererseits eine Potentialtrennung notwendig. Dem Stand der Technik entsprechend, sind verschiedenen Möglichkeiten der Potentialtrennung bekannt, beispielhaft Transformatoren, sog. Übertrager (40, 44), Optokoppler, Lichtwellenleiter oder elektronische Bauelemente mit entsprechender Spannungsfestigkeit. Weiterhin wird die Sekundärseite häufig von der Primärseite mittels eines DC/DC- Wandlers (42, 46) mit Spannung versorgt. Es sind nach dem Stand der Technik einzelne DC/DC- Wandler für jede Sekundärseite bekannt. Ebenso bekannt sind aber auch DC/DC- Wandler mit einer primärseitigen und einer Mehrzahl sekundärseitiger Wicklungen um somit eine Mehrzahl von Sekundärseiten mit Energie zu versorgen.

Mit den genannten Bauelementen zur Potentialtrennung können Ein- und Ausschaltsignale von der Primärseite (20) auf die Sekundärseite (30, 32) übertragen werden. Wesentlich für den störungsfreien Betrieb eines leistungselektronischen Systems ist allerdings auf der Primärseite (20) die Kenntnis von Betriebszuständen der Sekundärseite (30), beispielhaft über aufgetretene Fehler bei der Ansteuerung oder der Funktion des TOP-(50) oder des BOT- Schalters (52).

Die Übertragung von Information von der Sekundärseite (30, 32) zu Primärseite (20) ist allerdings nur möglich, wenn die Primärseite diese Übertragung explizit erlaubt. Dies geschieht ausschließlich dann, wenn die Primärseite (20) ein Zeitfenster in einem definierten zeitlichen Abstand nach einem Steuerimpuls (Einschaltsignal) freigibt. Innerhalb dieses Fensters kann dann die Sekundärseite einen Fehlerimpuls an die Primärseite senden. Die Primärseite kann somit erkennen, ob auf der Sekundärseite ein Fehler in einem dortigen Fehlerspeicher vorgelegen hat. Die Primärseite empfängt keine weitern Informationen von der Sekundärseite und muss somit ohne exakt zu wissen welcher Fehler vorliegt eine Gegenmaßnahme ergreifen.

Typischerweise führt ein Fehlerfall der Sekundärseite (30, 32) zur Übertragung eines Fehlerimpulses zur Primärseite, worauf primärseitig ausgelöst alle Leistungshalbleiterschalter abgeschaltet werden, wozu Ausschaltsignale von der Primärseite (20) zur Sekundärseite (30, 32) übertragen werden. Nach dieser Abschaltung sind die Übertragungskanäle (40, 44) für eine definierte Zeitspanne blockiert, wodurch die Primärseite keine weiteren Daten von der Sekundärseite (30, 32) empfangen kann. Die Zeitspanne der Blockierung wird in der Regel durch die übergeordnete Steuerung (10) festgelegt.

Fig. 2 zeigt eine erfindungsgemäß weitergebildete Schaltungsanordnung, die getrennt als Primärseite (20) und als mindestens eine Sekundärseite (30, 32) auch als monolithisch integrierte Schaltungsanordnung realisiert werden kann. Auf der Primärseite (20) sind hierbei weitere Schaltungsteile, wie eine erweiterte Regelung (204) des Eingangssignals des DC/DC- Wandlers und ein Schaltungsteil zur Erfassung (202) von der Sekundärseite (30, 32) gesendeter Informationen, notwendig. Die Sekundärseite muss erfindungsgemäß einen Schaltungsteil (302) zur Fehler- und/oder Statuserfassung, sowie eine Schaltung (304) zur Bestimmung der mittels des DC/DC- Wandlers (42, 46) übertragenen Spannung aufweisen.

Die Sekundärseite (30 ,32) weist in der erfindungsgemäßen Weiterbildung eine Mehrzahl von Überwachungsfunktionen auf, deren Ergebinis in dem Schaltungsteil (302) zur Fehler- und/oder Statuserfassung gespeichert werden. Sobald hier als signifikant definierte Fehler oder sonstige Statusinformationen vorliegen, übermittelt die Sekundärseite (30, 32) einen nach dem Stand der Technik bekannten Fehlerimpuls mittels des Übertragers (42, 46) an die Primärseite.

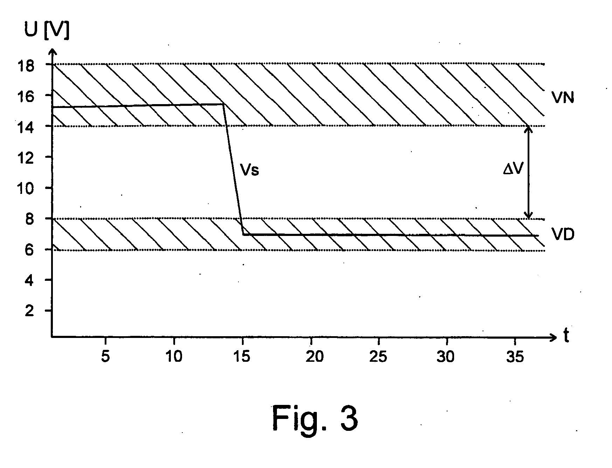

Dieser Fehlerimpuls kann nun durch die Primärseite (20) oder durch die übergeordnete Steuerung (10), an die dieser Impuls in aufbereiteter Form weitergeleitet wird, als Hinweis auf einen Fehler oder auch nur als Warnsignal interpretiert werden. In Falle eines derartigen Signals schaltet die übergeordneten Steuerung (10) oder auch die Primärseite (20) zu einem geeigneten Zeitpunkt auf den Diagnosemodus um. Hierbei wird nun von der Primärseite her gesteuert die Eingangsspannung des DC/DC- Wandlers (42, 46) reduziert. Dies bewirkt gemäß Fig. 3 eine Reduktion der Ausgangsspannung (Vs) des DC/DC-Wandlers auf das Diagnoseniveau (VD) von beispielhaft 6V bis 8V, welche durch den entsprechenden Schaltungsteil (304) als Diagnosezustand interpretiert wird. Das Diagnoseniveau (VD) kann ebenso bei höheren Spannungswerten im Vergleich zum Normalpegel (VN) liegen. Dies ist vorteilhaft, weil somit eine Reduktion der Spannung nicht erst als zu geringe Versorgungsspannungs interpretiert wird.

Bei einem DC/DC- Wandler pro Sekundärseite (30, 32) kann jede Sekundärseite (30, 32) einzeln, vorteilhafterweise werden aber alle Sekundärseiten (30, 32), von der Primärseite (20) in den Diagnosezustand versetzt werden. Bei Schaltungsanordnungen von einem DC/DC- Wandler für mehrere Sekundärseiten werden selbstverständlich alle gleichermaßen in den Diagnosezustand versetzt.

Diese Spannungsänderung der sekundärseitigen Ausgangsspannung (Vs) des DC/DC- Wandlers versetzt nun die Sekundärseite (30, 32) in den Diagnosemodus, bei dem keine Ansteuerung der Leistungshalbleiterschalter (50, 52) mehr vorgenommen wird. Die Leistungshalbleiterschalter (50, 52) können erst nach Beendigung des Diagonosemodus, also nach einer weiteren Änderung der über den DC/DC- Wandler (42, 46) übertragenen Versorgungsspannung zurück auf den Normalpegel (VN), der beispielhaft zwischen 14V und 18V liegt, wieder angesteuert werden.

Im Diagnosefall ist nun mittels des Übertragers (40, 44) eine Übermittelung von Fehler- und/oder Statusinformationen von der Sekundärseite (30, 32) zur Primärseite (20) möglich. Vorteilhafterweise ist hierbei eine bidirektionale Kommunikation zwischen der Primärseite und jeder einzelnen Sekundärseite (30, 32) gegeben. Dies bietet den Vorteil, eine einzelne Sekundärseite (30, oder 32) gezielt ansprechen zu können. Beispielhaft kann bei dieser Kommunikation die Primärseite (20) die Übermittelung der Fehler- und/oder Statusinformationen, welche sekundärseitig (30, 32) in Fehlerspeichern gespeichert sind, explizit anfordern.

Die von der Primärseite (20) erhaltenen Fehler- und/oder Statusinformationen können nun direkt, durch Schaltungsanordnungen auf der Primärseite, oder mittels der übergeordneten Steuerung (10) ausgewertet werden und entsprechende hieraus abgeleitete Maßnahmen ergriffen werden.

Vorteilhaft an der erfindungsgemäßen Ausgestaltung der Schaltungsanordnung ist, dass für die bidirektionale Übertragung einer Mehrzahl von Informationen zwischen der Primärseite (20) und der Sekundärseite (30, 32) ausschließlich mittels bereits nach dem Stand der Technik vorhandene Komponenten, wie Übertrager (40, 44) und DC/DC- Wandler (42, 46) notwendig sind. Die zusätzlichen Schaltungsteile (202, 204, 302, 304) auf der Primärseite (20) bzw. der Sekundärseite (30, 32) sind speziell bei monolithisch integrierten Schaltungen einfach und kostengünstig zu realisieren.

## Patentansprüche

1. Schaltungsanordnung zur Ansteuerung von Leistungshalbleiterschaltern (50, 52) in Brückentopologie bestehend aus einer Primärseite (20) und jeweils einer Sekundärseite (30, 32) für den TOP- (50) und den BOT-5 Schalter (52) der Brückenschaltung, mindestens einen Übertrager (40, 44) pro steuerbaren Leistungshalbleiterschalter (50, 52) zur potentialfreien Übertragung des Steuersignals zwischen der Primärseite (20) und mindestens einer Sekundärseite (30, 32) und mindestens einem DC/DC- Wandler (42, 46) zur Spannungsversorgung der Sekundärseite (30, 32) von der Primärseite (20) aus, wobei auf der Sekundärseit Schaltungsteile (302) zur Fehlerspeicherung und Übertragung der Fehler- und/oder Statusinformationen von der Sekundärseite zur Primärseite vorgesehen sind, wobei auf der Primärseite Schaltungsteile (202) zur Erfassung der über den Übertrager (42, 46) von der Sekundärseite (30, 32) zur Primärseite (20) übertragenen Fehler- und/oder Statusinformationen vorgesehen sind, **dadurch gekennzeichnet, dass** auf der Primärseite weitere Schaltungsteile (204) zur Einstellung verschiedener Spannungswerte am DC/DC- Wandler einfügen vorgesehen sin und dass auf der Sekundärseite weitere Schaltungsteile (304) vorgesehen sind, die die sekundärseitige Spannung (VS) des DC/DC- Wandlers auswerten können einfügen.

2. Verfahren zur Übermittlung von Fehler- und/oder Statusinformationen von der Sekundärseite (30 32) zur Primärseite (20) in einer Schaltungsanordnung zu Ansteuerung von Leistungshalbleiterschaltern (50, 52) nach Anspruch 1, wobei
- im fehlerfreien Betreib von der Primärseite (20) über den DC/DC- Wandler (42, 46) zur Sekundärseite (30, 32) Energie mit einer sekundärseitigen Spannung in einem ersten Spannungsintervall (Vs) übertragen wird und über den Übertrager (42, 46) die Steuerimpulse für die Leistungshalbleiterschalter (50, 52) übertragen werden;
- im Fehlerfall die Sekundärseite (30, 32) über den Übertrager (42, 46) einen Fehlerimpuls an die Primärseite (20) übermittelt;
- daraufhin die Primärseite (20) nach Abschalten aller aktiv steuerbaren Leistungshalbleiterschalter auf Befehl der übergeordneten Steuerung (10) die Energieübertragung mittels des DC/DC- Wandlers (42, 46) derart ändert, dass die sekundärseitige Spannung (Vs) ein zweites Spannungsintervall (VD) aufweist, wobei dieses zweite Spannungsintervall (VD) zum ersten Spannungsinterfall (VN) einen Spannungsunterschied (ΔV) aufweist;
- dieser Spannungsunterschied (ΔV) auf der Sekundärseite (30, 32) erkannt wird und als Umschalten in einen Diagnosemodus interpretiert wird und
- im Diagnosemodus von der Sekundärseite (30, 32) an die Primärseite (20) Fehler- und/oder Statusinformationen mittels des Übertragers (42, 46) übermittelt werden.

3. Verfahren nach Anspruch 2,
wobei im Diagnosemodus von der Sekundärseite (30, 32) keine Steuersignale an den zugeordneten Leistungshalbleiterschalter (50, 52) übermittelt werden.

4. Verfahren nach Anspruch 2,
wobei im Diagnosemodus die Übertragung zwischen Sekundärseite (30, 32) und Primärseite (20) bidirektional ist.

5. Verfahren nach Anspruch 2,
wobei das erste Spannungsintervall (VN) einen Spannungsbereich zwischen 14V und 18V umfasst, das zweite Spannungsintervall (VD) einen Spannungsbereich zwischen 6V und 8V umfasst und somit der Spannungsunterschied (ΔV) der Intervalle 6V umfasst.

6. Verfahren nach Anspruch 2,
wobei das zweite Spannungsintervall (VD) zur Aktivierung des Diagnosemodus oberhalb des ersten Spannungsintervalls (VN) liegt.

## Claims

1. A circuit arrangement for controlling power semiconductor switches (50, 52) in bridge topology consisting of a primary side (20) and in each case a secondary side (30, 32) for the TOP (50) and the BOT switch (52) of the bridge circuit, at least one matching transformer (40, 44) per controllable power semiconductor switch (50, 52) for the potential-free transmission of the control signal between the primary side (20) and at least one secondary side (30, 32) and at least one DC/DC converter (42, 46) for voltage supply of the secondary side (30, 32) from the primary side (20), wherein circuit parts (302) for error storage and transmission of error and/or status information from the secondary side to the primary side are provided on the secondary side, wherein circuit parts (202) for detecting the error and/or status information transmitted via the matching transformer (42, 46) from the secondary side (30, 32) to the primary side (20) are provided on the primary side, **characterised in that** further circuit parts (204) for adjusting various voltage values at the DC/DC converter are provided on the primary side and that further circuit parts (304) which can evaluate the secondary-side voltage (VS) of the DC/DC converter are provided on the secondary side.

2. A method for transmitting error and/or status information from the secondary side (30, 32) to the primary side (20) in a circuit arrangement for controlling power semiconductor switches (50, 52) according to claim 1, wherein
- during error-free operation energy having a secondary-side voltage in a first voltage interval (Vs) is transmitted from the primary side (20) via the DC/DC converter (42, 46) to the secondary side (30, 32) and the control pulses for the power semiconductor switch (50, 52) are transmitted via the matching transformer (42, 46);
- in the event of an error, the secondary side (30, 32) transmits an error pulse to the primary side (20) via the matching transformer (42, 46);
- after switching off all the actively controllable power semiconductor switches at the command of the superordinate control (10), the primary side (20) modifies the energy transmission by means of the DC/DC converter (42, 46) in such a manner that the secondary-side voltage (Vs) has a second voltage interval (VD), wherein this second voltage interval (VD) has a voltage difference (ΔV) from the first voltage interval (VN);
- this voltage difference (ΔV) is detected on the secondary side (30, 32) and is interpreted as switching over to a diagnostic mode and
- in the diagnostic mode error and/or status information is transmitted from the secondary side (30, 32) to the primary side (20) by means of the matching transformer (42, 46).

3. The method according to claim 2,
wherein in the diagnostic mode no control signals are transmitted from the secondary side (30, 32) to the allocated power semiconductor switches (50, 52).

4. The method according to claim 2,
wherein in the diagnostic mode the transmission between secondary side (30, 32) and primary side (20) is bidirectional.

5. The method according to claim 2,
wherein the first voltage interval (VN) comprises a voltage range between 14 V and 18 V, the second voltage interval (VD) comprises a voltage range between 6 V and 8 V, and therefore the voltage difference (ΔV) comprises the interval 6 V.

6. The method according to claim 2,
wherein the second voltage interval (VD) for activating the diagnostic mode lies above the first voltage interval (VN).

## Revendications

1. Dispositif de circuit destiné à attaquer des commutateurs semiconducteurs de puissance (50, 52) ayant une topologie en pont, composés d'un côté primaire (20) et chacun d'un côté secondaire (30, 32) pour le commutateur du dessus (20) et le commutateur du dessous (52) du circuit en pont, au moins un transmetteur (40, 44) par commutateur semiconducteur de puissance (50, 52) asservi, afin de transmettre sans potentiel le signal de commande entre le côté primaire (20) et au moins un côté secondaire (30, 32) et au moins un convertisseur continu-continu (42, 46) pour alimenter le côté secondaire (30, 32) en tension à partir du côté primaire (20), dans lequel il est prévu sur le côté secondaire des éléments de circuit (302) destinés à mémoriser les erreurs et à transmettre les informations d'erreur et/ou d'état entre le côté secondaire et le côté primaire, dans lequel il est prévu sur le côté primaire des éléments de circuit (202) destinés à recueillir les informations d'erreur et/ou d'état transmises entre le côté secondaire (30, 32) et le côté primaire (20) par le transmetteur (42, 46), **caractérisé en ce qu'**il est prévu sur le côté primaire d'autres éléments de circuit (204) destinés à régler différentes valeurs de tension sur le convertisseur continu-continu et **en ce qu'**il est prévu sur le côté secondaire d'autres éléments de circuit (304) qui peuvent analyser la tension côté secondaire (VS) du convertisseur continu-continu.

2. Procédé de transmission d'informations d'erreur et/ou d'état entre le côté secondaire (30, 32) et le côté primaire (20) dans un dispositif de circuit destiné à attaquer des commutateurs semiconducteurs de puissance (50, 52) selon la revendication 1,
- dans lequel, dans un fonctionnement sans erreur, le côté primaire (20) envoie au côté secondaire (30, 32), via le convertisseur continu-continu (42, 46), de l'énergie ayant une tension côté secondaire située dans un premier intervalle de tension (Vs) et les impulsions de commande des commutateurs semiconducteurs de puissance (50, 52) sont transmises via le transmetteur (42, 46) ;
- dans lequel, en cas d'erreur, le côté secondaire (30, 32) envoie une impulsion d'erreur au côté primaire (20) via le transmetteur (42, 46) ;
- après quoi le côté primaire (20), ayant coupé tous les commutateurs semiconducteurs de puissance asservis activement sur ordre de la commande hiérarchiquement supérieure (10), fait varier la transmission d'énergie à l'aide du convertisseur continu-continu (42, 46) de telle manière que la tension côté secondaire (Vs) se situe dans un second intervalle de tension (VD), ce second intervalle de tension (VD) présentant par rapport au premier intervalle de tension (VN) une différence de tension (ΔV) ;
- dans lequel cette différence de tension (ΔV) est détectée sur le côté secondaire (30, 32) et est interprétée comme un ordre de commutation en mode de diagnostic ; et
- dans lequel, en mode de diagnostic, le côté secondaire (30, 32) envoie au côté primaire (20) des informations d'erreur et/ou d'état via le transmetteur (42, 46).

3. Procédé selon la revendication 2, dans lequel, en mode de diagnostic, le côté secondaire (30, 32) n'envoie pas de signaux de commande aux commutateurs semiconducteurs de puissance (50, 52) correspondants.

4. Procédé selon la revendication 2, dans lequel, en mode de diagnostic, la transmission entre le côté secondaire (30, 32) et le côté primaire (20) est bidirectionnelle.

5. Procédé selon la revendication 2, dans lequel le premier intervalle de tension (VN) comprend une plage de tensions entre 14 V et 18 V, le second intervalle de tension (VD) comprend une plage de tensions entre 6 V et 8 V et la différence de tension (ΔV) des intervalles est donc de 6 V.

6. Procédé selon la revendication 2, dans lequel le second intervalle de tension (VD), pour l'activation du mode de diagnostic, se situe au-dessus du premier intervalle de tension (VN).
